(19) Europäisches Patentamt
European Patent Office
Office européen des brevets

(11) Veröffentlichungsnummer: **0 499 792 A1**

(12) **EUROPÄISCHE PATENTANMELDUNG**

(21) Anmeldenummer: **92100714.2**

(51) Int. Cl.$^5$: **G03F 7/11**, C09J 175/14

(22) Anmeldetag: **17.01.92**

(30) Priorität: **09.02.91 DE 4104005**

(43) Veröffentlichungstag der Anmeldung:
**26.08.92 Patentblatt 92/35**

(84) Benannte Vertragsstaaten:
**DE FR GB**

(71) Anmelder: **BASF Aktiengesellschaft**
**Carl-Bosch-Strasse 38**
**W-6700 Ludwigshafen(DE)**

(72) Erfinder: **Kurtz, Karl-Rudolf, Dr.**
**Am Rain 2**
**W-6900 Heidelberg(DE)**
Erfinder: **Keppeler, Uwe, Dr.**
**Ungsteiner Strasse 22**
**W-6700 Ludwigshafen(DE)**
Erfinder: **Koch, Horst, Dr.**
**Wagnerstrasse 4**
**W-6520 Worms 24(DE)**
Erfinder: **Telser, Thomas, Dr.**
**Langer Wiesenweg 13**
**W-6940 Weinheim(DE)**

(54) **Haftsystem für photopolymere Druckplatten.**

(57) Die Erfindung betrifft ein Haftsystem für photopolymere Druckplatten, enthaltend als wesentliche Komponenten

a) ein olefinisch ungesättigtes Polyurethan,
b) ein schlagzäh modifizierendes Mittel und
c) mindestens eine niedermolekulare organische Substanz mit mehreren Isocyanatgruppen.

EP 0 499 792 A1

Die Erfindung betrifft ein Haftsystem für photopolymere Druckplatten, vor allem für Flexodruckplatten.

Die Erfindung betrifft insbesondere ein Haftsystem aus den Komponenten

a) olefinisch ungesättigtes thermoplastisches Polyurethan,

b) schlagzäh modifizierendes Mittel,

c) mindestens eine niedermolekulare organische Substanz mit mehreren Isocyanatgruppen,

und gegebenenfalls

d) Zusatzstoffen (z.B. Lichthofschutzmittel).

Bei den üblichen Flexodruckplatten sind auf einem Träger eine reliefbildende Schicht (Reliefschicht) und hierauf wiederum eine Deckfolie aufgebracht.

Da die Verbindung Reliefschicht/Träger während der Prozeßzeiten zur Herstellung eines Klischees und vor allem während des folgenden Druckprozesses einer starken mechanischen Belastung ausgesetzt ist, wird üblicherweise zur Verbesserung der Adhäsion vor dem Laminieren des Verbundes eine Haftschicht auf den Träger aufgebracht.

Eine solche Haftschicht ist beispielsweise in US-A 4,415,649 beschrieben. Hierbei besteht die Haftschicht aus einer Mischung von mindestens zwei von vier Komponenten, die aus einem Polyesterharz, einem Polyether-polyurethanharz und zwei Polyamiden ausgewählt sind.

In EP-A 246 918 sind härtbare Präpolymere beschrieben, die durch Umsetzung von (meth)acrylierten polymeren Kohlenwasserstoffen mit Maleinsäure erhalten werden. Diese Präpolymere können entweder alleine oder mit mono- oder multifunktionellen ungesättigten Monomeren und geeigneten thermischen oder photochemischen Initiatoren zu Materialien umgesetzt werden, die sich beispielsweise für Druckplatten, Klebstoffe oder Beschichtungen eignen.

Eine weitere Gruppe von Haftlacken beruht auf carboxylgruppenhaltigen Polymeren (SU 991442; Research Disclosure 266-049, June 1986, 357 bis 359), teilweise modifiziert mit Epoxidharzen (SU 934439).

Daneben gibt es Haftlacksysteme auf Basis von Polymeren, wie sie zur Herstellung der eigentlichen Reliefschicht benutzt werden (EP-A 246 918; EP-A 333 012).

In der EP-A 333 012 enthalten diese Haftlacksysteme bestimmte Arylglycidylether(meth)acrylate in zumindest teilweise polymerisiertem Zustand oder bestehen ausschließlich aus diesen.

Aus der EP-A 36 301 ist ein lichtempfindliches Polyamidharzgemisch aus alkohollöslichem Polyamid, einer nicht polymeren Verbindung, die in ein und demselben Molekül sowohl Vinyl- als auch Epoxygruppen aufweist und mit dem polymeren Bindemittel unter Bildung copolymerisationsfähiger Polymerer reagieren kann sowie einem polyfunktionellen Vinylmonomeren mit

$$-O-CH_2-\underset{\overset{|}{OH}}{CH}-CH_2-O-CO-CR{=}CH_2\text{-Gruppierungen,}$$

darunter auch Phenylglycidyletheracrylat, als weichmachende Komponente, mit polyfunktionellen Acrylaten kombiniert, in photopolymerisierbaren Druckplatten, die alkohollösliches modifiziertes Polyamid als polymeres Bindemittel enthalten, beschrieben. Es wird hier also als weichmachende Komponente in der Reliefschicht eingesetzt.

Nachteilig bei der Anwendung der genannten Haftschichten ist die Notwendigkeit zur exakten Abstimmung der Lackeigenschaften auf die chemische Zusammensetzung der Reliefschicht und die Oberflächenbeschaffenheit des Trägers. Bei geringen Änderungen der Reliefschichteigenschaften oder Wechsel des Trägers sind zeit- und materialaufwendige Arbeiten zur Wiederherstellung des ursprünglichen Haftungsniveaus notwendig.

Ein weiterer Nachteil besteht darin, daß oftmals die geforderten guten Haftungseigenschaften nur durch das Aufbringen zweier oder mehrerer Haftschichten übereinander erreicht werden kann. Die meisten Haftlacksysteme sind zudem bei höheren Monomerkonzentrationen in der Reliefschicht empfindlich gegenüber eindiffundierenden Monomeren, die bei der Vor- bzw. bildmäßigen Belichtung eine Versprödung des Haftsystems mit anschließendem Haftungsversagen verursachen. Diese Diffusion muß gegebenenfalls durch das Aufbringen einer weiteren, sperrenden Schicht unterdrückt werden, wodurch ein weiterer Arbeitsschritt notwendig wird.

Das Haftungsniveau der nach dem Stand der Technik haftvermittelten Trägerfolien nimmt zudem - vor allem bei reaktiven Haftsystemen - mit zunehmender Lagerdauer ab, so daß aufwendige Logistikmaßnahmen bei der Produktion der Druckplatten notwendig sind.

Aufgabe der Erfindung war es deshalb, ein Haftsystem zu finden, das zu einer Vielzahl chemisch unterschiedlicher Reliefschichten auf unterschiedlichsten Trägermaterialien gute Haftung zeigt. Weiterhin

sollte das Aufbringen einer einzigen Schicht ausreichend sein, die sowohl gegenüber Monomerdiffusion unempfindlich ist als auch eine hohe Resistenz gegenüber Entwicklermedien und Farblösungsmitteln zeigt.

Das Haftungsniveau sollte über einen längeren Zeitraum nicht oder nur gering abfallen, um so längere Lagerzeiten der haftvermittelten Träger zu ermöglichen.

Diese Aufgabe wurde erfindungsgemäß durch Haftsysteme gemäß Anspruch 1 gelöst.

Bevorzugte Haftsysteme enthalten als olefinisch ungesättigtes thermoplastisches Polyurethan ein solches mit einem Molekulargewicht ($\overline{M}_{\overline{w}}$) im Bereich von 40 000 bis 200 000, welches aus

A) einem Gemisch aus
  A1) einem Polydiol mit einem Molekulargewicht zwischen 400 und 4000 und
  A2) einem Polydiol mit einem Molekulargewicht von größer 14 000,
B) einem Gemisch aus
  B1) einem oder mehreren nicht olefinisch ungesättigten Diolen mit 2 bis 20 Kohlenstoffatomen und
  B2) einem oder mehreren Diolen mit 2 bis 20 Kohlenstoffatomen mit jeweils mindestens einer olefinisch ungesättigten Bindung,
C) mindestens einem Tri- oder Polyol mit 3 bis 10 Kohlenstoffatomen,
D) mindestens einem Diisocyanat mit 6 bis 30 Kohlenstoffatomen und
E) mindestens einem Monoamin oder Aminoalkohol mit 2 bis 16 Kohlenstoffatomen

hergestellt wird.

Besonders bevorzugte erfindungsgemäße Haftsysteme (im folgenden auch Haftlacke genannt) enthalten olefinisch ungesättigte thermoplastische Polyurethane, die aus

A) 1 Mol eines Gemisches aus
  A1) einem Polydiol mit einem Molekulargewicht zwischen 400 und 4 000 und
  A2) einem Polydiol mit einem Molekulargewicht von größer 14 000,
  wobei das Molverhältnis der Komponente A1) zu der Komponente A2) ≧ 10 ist,
B) 0,3 bis 10 Mol eines Gemisches aus
  B1) einem oder mehreren nicht olefinisch ungesättigten Diolen mit 2 bis 20 Kohlenstoffatomen und
  B2) einem oder mehreren Diolen mit 2 bis 20 Kohlenstoffatomen mit jeweils mindestens einer olefinisch ungesättigten Bindung,
  wobei das Molverhältnis der Komponente B1) zu der Komponente B2) ≦ 30 ist,
C) 0,05 bis 0,5 Mol mindestens einem Tri- oder Polyol mit 3 bis 10 Kohlenstoffatomen,
D) 1,3 bis 13 Mol mindestens einem Diisocyanat mit 6 bis 16 Kohlenstoffatomen und
E) 0,09 bis 2 Mol mindestens einem Monoamin mit 2 bis 16 Kohlenstoffatomen

hergestellt werden, mit der Maßgabe, daß das Verhältnis der OH-Gruppen der Komponenten A) bis C) zu den NCO-Gruppen der Komponente D) zu den Aminogruppen der Komponente E) wie 1 zu 1,03 bis 1,3 zu 0,03 bis 0,3 beträgt.

Die Molekulargewichtsangaben beziehen sich hierbei und im folgenden auf das Gewichtsmittel.

In einer besonders bevorzugten Ausführungsform sind die Komponenten A) bis E) so gewählt, daß

A1) ein Polycarbonatdiol auf Basis von 1,6-Hexandiol,
A2) ein linearer Copolyester auf der Basis von Polyethylenterephthalat,,
B1) 1,6-Hexandiol und/oder ethoxyliertes 2,2-Bis(4-hydroxyphenyl)-propan,
B2) Bisphenol-A-diglycidyldiacrylat,
C) Trimethylolpropan,
D) Toluylen-2,4- bzw. -2,6-diisocyanat und/oder 4,4'-Diphenylmethandiisocyanat und
E) Dibutylamin

ist.

Das die erfindungsgemäßen Haftsysteme charakterisierende olefinisch ungesättigte thermoplastische Polyurethan wird aus an sich bekannten Komponenten aufgebaut.

Als Komponente A1) (Polydiol) wird bevorzugt ein Polyesterdiol, Polyetherdiol oder Polycarbonatdiol mit einem Molekulargewicht von 400 bis 4 000, besonders bevorzugt von 700 bis 2 500, eingesetzt. Die Polydiole sind zweckmäßigerweise überwiegend lineare Polymere mit zwei endständigen OH-Gruppen. Die Säurezahl der Polydiole ist kleiner als 10 und vorzugsweise kleiner als 3.

Die Polyesterdiole lassen sich in einfacher Weise durch Veresterung von aliphatischen oder aromatischen Dicarbonsäuren mit 4 bis 15 C-Atomen, vorzugsweise 4 bis 8 C-Atomen, mit aliphatischen oder cycloaliphatischen Glykolen, bevorzugt mit 2 bis 25 C-Atomen, oder durch Polymerisation von Lactonen mit 3 bis 20 C-Atomen herstellen. Als Dicarbonsäuren lassen sich beispielsweise Glutarsäure, Pimelinsäure, Korksäure, Sebacinsäure, Dodecansäure, Terephthalsäure, Isophthalsäure und vorzugsweise Adipinsäure, Bernsteinsäure und Phthalsäuren einsetzen. Die Dicarbonsäuren können einzeln oder als Gemische verwendet werden. Zur Herstellung der Polyesterdiole kann es gegebenenfalls vorteilhaft sein, anstelle der

Dicarbonsäuren die entsprechenden Säurederivate, wie Carbonsäureanhydride oder Carbonsäurechloride zu verwenden. Beispiele für geeignete Glykole sind Diethylenglykol, 1,5-Pentandiol, 1,10-Decandiol und 2,2,4-Trimethyl1,5-pentandiol. Vorzugsweise verwendet werden 1,2-Ethandiol, 1,4-Butandiol, 1,6-Hexandiol und 2,2-Dimethyl-1,3-propandiol, 1,4-Dimethylolcyclohexan, 1,4-Diethanolcyclohexan, 1,3-Diethanolpropan und ethoxylierte/propoxylierte Produkte des 2,2-Bis-(4-hydroxy-phenyl)propan (Bisphenol A). Als Lactone für die Herstellung der Polyesterdiole eignen sich z.B. $\alpha,\alpha$-Dimethyl-ß-propiolacton, $\gamma$-Butyrolacton und vorzugsweise $\epsilon$-Caprolacton.

Die Polyetherdiole sind im wesentlichen lineare, endständige Hydroxylgruppen aufweisende Substanzen, die Etherbindungen enthalten und ein Molekulargewicht von vorzugsweise 400 bis 4000, besonders bevorzugt von 1000 bis 2000, besitzen. Polyetherdiole sind beispielsweise Polytetrahydrofuran oder Polypropylenoxiddiol. Geeignete Polyetherdiole können leicht durch Polymerisation von cyclischen Ethern, wie Tetrahydrofuran, oder durch Umsetzung von einem oder mehreren Alkylenoxiden mit 2 bis 4 Kohlenstoffatomen im Alkylenrest mit einem Startermolekül, das zwei aktive Wasserstoffatome im Alkylenrest gebunden enthält, hergestellt werden. Als Alkylenoxide seien beispielsweise genannt: Ethylenoxid, 1,2-Propylenoxid, Epichlorhydrin, 1,2- und 2,3-Butylenoxid. Die Alkylenoxide können einzeln, alternierend nacheinander oder als Mischung verwendet werden. Als Startermoleküle kommen beispielsweise in Betracht: Wasser, Glykole, wie Ethylenglykol, Propylenglykol, 1,4-Butandiol und 1,6-Hexandiol, Amine wie Ethylendiamin, Hexamethylendiamin und 4,4'-Diamino-diphenylmethan und Aminoalkohole, wie Ethanolamin. Ebenso wie die Polyesterdiole können auch die Polyetherdiole allein oder in Mischungen verwendet werden.

Polycarbonatdiole sind ebenfalls gut geeignet. Als Polycarbonatdiole kommen solche auf Basis von aromatischen Dihydroxyverbindungen, z.B. Bisphenol A, oder solche auf Basis aliphatischer Dihydroxyverbindungen, z.B. 1,6-Hexandiol, in Frage. Die Molmassen erstrecken sich von 400 bis 4000, vorzugsweise von 1000 bis 2000.

Als Komponente A2) (Polydiol) wird vorzugsweise ein Polyester mit einem Molekulargewicht von größer 14 000 ($\overline{M}_w$) eingesetzt. Bei den Produkten handelt es sich vorzugsweise um lösliche, lineare, thermoplastische Copolyester mit zwei endständigen OH-Gruppen.

Die Produkte enthalten in der Regel aromatische Bestandteile. Bevorzugt sind hiervon lineare Copolyester auf der Basis von Polyethylenterephthalat. Entsprechende kommerzielle Produkte sind z.B. die ®Dynapol L-Typen der Fa. Dynamit Nobel oder das ®PE 49 000 der Fa. DuPont.

Als Komponente B1) werden nicht olefinisch ungesättigte Diole mit 2 bis 20 Kohlenstoffatomen eingesetzt.

Als Komponente B1) eignen sich aromatische Diole, vorzugsweise Bisphenol A bzw. dessen Derivate. Entsprechende Produkte sind z.B. unter dem Namen Dianol® 22 oder Dianol® 33 von der Fa. Akzo erhältlich.

Als Komponente B1) können außerdem geradkettige aliphatische Diole mit 2 bis 20 C-Atomen, vorzugsweise 4 bis 6 C-Atomen, eingesetzt werden, so z.B. 1,2-Ethandiol, 1,3-Propandiol, 1,4-Butandiol, 1,6-Hexandiol, 1,5-Pentandiol, 1,10-Decandiol, 2-Methyl-1,3-propandiol, 2-Methyl-2-butyl-1,3-propandiol, 2,2-Dimethyl-1,4-butandiol, 2-Methyl-2-butyl-1,3-propandiol, Hydroxypivalinsäureneopentylglykolester, Diethylenglykol, Triethylenglykol und Methyldiethanolamin, 1,4-Dimethylolcyclohexan, 1,4-Diethanolcyclohexan.

Die genannten Diole können teilweise oder vollständig durch Wasser ersetzt werden.

Als Komponente B2) werden ein oder mehrere Diole mit jeweils mindestens einer olefinisch ungesättigten Bindung eingesetzt.

Vorzugsweise werden als Komponente B2) Diole verwendet, die mindestens eine zusätzliche Acrylatdoppelbindung im Molekül besitzen. Beispiele sind das instabile 2,3-Dihydroxypropylacrylat oder Reaktionsprodukte von Epoxidverbindungen mit polymerisierbaren olefinisch ungesättigten Carbonsäuren, insbesondere Acrylsäure, wobei jeweils etwa auf jede Epoxidgruppe eine Carboxylgruppe kommt, sowie Reaktionsprodukte von Dicarbonsäuren mit polymerisierbaren olefinisch ungesättigten Glycidylverbindungen, wie sie z.B. in der DE-A 21 64 386 beschrieben sind.

Die entsprechenden (auch als Polyurethanacrylate bezeichneten) olefinisch ungesättigten thermoplastischen Polyurethane sind erfindungsgemäß besonders bevorzugt.

Als ungesättigtes Acrylesterdiol können auch Umsetzungsprodukte aus OH-Gruppen-tragenden Monoepoxiden wie Glycidol (2,3-Epoxypropanol-1) mit Acrylsäure herangezogen werden. Geeignete polymerisierbare Diole (Polyole) können z.B. aus Epoxiden mit zwei endständigen Epoxidgruppen gemäß der allgemeinen Formel (vgl. auch US-A 3 373 075)

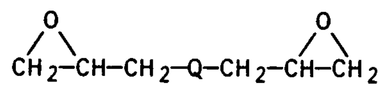

erhalten werden, in der Q ein zweibindiges Radikal bedeutet, wie z.B. -O-,

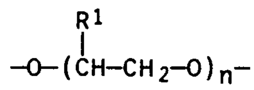

mit n = 1 bis 10, wobei $R^1$ für Wasserstoff oder Methyl steht, d.h. also ein von Ethylenglykol oder Propylenglykol abgeleitetes Radikal, oder aber einen $-O-(CH_2)_m-O-$Rest mit m = 1 bis 10, vorzugsweise 1 bis 7, bedeutet. Das Radikal Q ist aber auch von Polyethylenglykol oder Polypropylenglykol herleitbar oder kann für den Rest der Formel

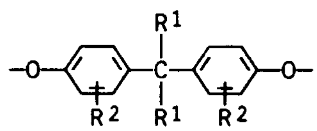

stehen, wobei dieses Radikal von 4,4'-Dihydroxydiphenylmethan, Bisphenol A oder kernsubstituierten Derivaten dieser Verbindungen hergeleitet werden kann. Die Umsetzungsprodukte der Epoxidverbindungen mit Acrylsäure sollten bei der späteren Umsetzung mit Diisocyanaten weitgehend bifunktionell in Bezug auf OH-Gruppen sein. Bei einer OH-Funktionalität 3 bestünde sonst die Gefahr der Vernetzung.

Die Umsetzung zwischen den Epoxidverbindungen und den polymerisierbaren olefinisch ungesättigten Säuremonomeren ist eine ringöffnende Veresterung zwischen den Epoxidgruppen der Epoxidverbindungen und den Carboxylgruppen insbesondere der polymerisierbaren Acrylsäure, die etwa analog der DE-A 21 64 386 in bekannter Weise ausgeführt werden kann (vgl. auch US-A 3 373 075 und US-A 28 24 851).

Die vorgenannten Epoxidverbindungen und deren Umsetzungsprodukte können allein oder im Gemisch verwendet werden. Bevorzugt eignen sich Umsetzungsprodukte aus Bisphenol A-Diglycidylether oder 2,3-Epoxypropanol-1 mit Acrylsäure.

Als Triole für die Komponente C) werden Verbindungen mit 3 bis 10, vorzugsweise 3 bis 6 C-Atomen eingesetzt. Beispiele für entsprechende Triole sind Glycerin oder Trimethylolpropan. Geeignet sind auch niedermolekulare Umsetzungsprodukte von z.B. Trimethylolpropan mit Ethylenoxid und/oder Propylenoxid. Das Vorhandensein von Triolen bei der Polyaddition führt zu einer Verzweigung des Endprodukts, was sich, sofern keine örtliche Vernetzung auftritt, positiv auf die mechanischen Eigenschaften des Polyurethans auswirkt. Als Polyole lassen sich beispielsweise Erythrit, Pentaerythrit und Sorbit einsetzen.

Zur Herstellung der erfindungsgemäßen olefinisch ungesättigten thermoplastischen Polyurethane werden die unter A), B) und C) genannten Komponenten mit aliphatischen, cycloaliphatischen oder aromatischen Diisocyanaten mit in der Regel 6 bis 30 C-Atomen (Komponente D)) umgesetzt, wobei zunächst NCO-gruppenhaltige Zwischenprodukte resultieren. Zu diesem Zweck eignen sich Verbindungen wie z.B. Toluylen-2,4-diisocyanat, Toluylen-2,6-diisocyanat, m-Phenylendiisocyanat, 4-Chlor-1,3-phenylendiisocyanat, 1,5-Naphthylendiisocyanat, 1,6-Hexamethylendiisocyanat, 1,4-Cyclohexylendiisocyanat und 1,5-Tetrahydronaphthylendiisocyanat, Diphenylmethandiisocyanat, Dicyclohexylmethandiisocyanat, Isophorondiisocyanat oder Gemische davon.

Die Polyadditionsreaktion läßt sich nach Erreichen des gewünschten Molekulargewichts durch Zugabe eines Monoalkohols oder Amins abbrechen, z.B. mit Dibutylamin, Diethylamin, Butylamin, Hexylamin, Methanol, Ethanol.

Hierbei können zur Bildung von erfindungsgemäßen olefinisch ungesättigten Polyurethanen mit OH-gruppenhaltigen Harnstoffgruppierungen die NCO-gruppenhaltigen Zwischenprodukte aus A) bis D) mit Aminoalkoholen als Komponente E) umgesetzt werden. Diese Aminoalkohole mit 2 bis 16, vorzugsweise 3 bis 6 C-Atomen sind u.a. Monoethanolamin, Methylisopropanolamin, Ethylisopropanolamin, Methylethanolamin, 3-Aminopropanol, 1-Ethylaminobutanol-2, 4-Methyl-4-aminopentanol-2, N-(2-Hydroxyethyl)anilin. Diolamine sind besonders geeignet, da durch ihre Anlagerung am Kettenende die OH-Zahl der Polymeren sehr stark erhöht wird. Als besonders günstig haben sich Diethanolamin und Diisopropanolamin erwiesen.

Erfindungsgemäß werden als Komponente E) mit 2 bis 16 Kohlenstoffatomen die Monoamine den Aminoalkoholen vorgezogen.

Das Verhältnis der Komponenten A) bis D) wird vorzugsweise von 1,3 bis 13 Mol Diisocyanat (D) je Mol Polydiol (A) bei Verwendung von 0,3 bis 10 Mol des Diols mit 2 bis 20 C-Atomen (B) und 0,05 bis 0,5 Mol Triol (C) variiert. Hierbei beträgt das Molverhältnis der Komponente B1) zu der Komponente B2) $\leqq$ 50 vorzugsweise $\leqq$ 30. Die Menge des verwendeten Diols (B)) hängt teilweise von dem Molekulargewicht des verwendeten Polydiols ab. Aus praktischen Gründen ist es jedoch zweckmäßig, einen Diisocyanatüberschuß von mindestens 3 % über der zur vollständigen Umsetzung der Reaktionsteilnehmer erforderlichen Menge zu verwenden, so daß das Verhältnis der Zahl der eingesetzten Isocyanatgruppen zur Zahl der Hydroxylgruppen in der Reaktionsmischung 1,03 bis 1,3, vorzugsweise 1,05 bis 1,15 beträgt. Der NCO-Überschuß wird dann stöchiometrisch mit den NH-Gruppen des Monoamins oder Aminoalkohols umgesetzt, so daß das Verhältnis der Komponenten (A) bis C)):D):E) 1:1,03 bis 1,3:0,03 bis 0,3, bevorzugt 1:1,05 bis 1,15:0,05 bis 0,15 beträgt.

Die so aufgebauten thermoplastischen, elastischen OH-gruppenhaltigen oder OH-gruppenfreien olefinisch ungesättigten Polyurethane, insbesondere Polyurethanacrylate, werden in Lösung nach einem Mehrstufenverfahren oder auch nach dem 2-Stufenverfahren, wie es beispielsweise in DE-A 25 00 921 beschrieben ist, gegebenenfalls in Gegenwart von Katalysatoren und anderen Hilfsmitteln und/oder Zusatzstoffen, hergestellt. Diese Produkte nach dem lösungsmittelfreien Batch-Verfahren herzustellen, ist nicht möglich. Da sich aufgrund der Anwesenheit des Triols und der Reaktion von Amin mit NCO-Gruppen bei der Substanzpolyaddition zumindest teilweise Gel-Teilchen bilden, wird in Lösung gearbeitet. Allgemein wird bei der Lösungspolyaddition die Gefahr einer örtlichen Übervernetzung, wie sie bei der Substanzpolyaddition auftritt, vermieden.

Beim 2-Stufenverfahren sind je nach Reaktionsbedingungen (z.B. Lösungsmittelmenge, Reaktionswärme, Reaktivität der Komponenten) unterschiedliche Fahrweisen möglich, die sich in der ersten Stufe unterscheiden. Im folgenden sind einige Beispiele für unterschiedliche Fahrweisen beschrieben:

Fahrweise 1: Die Komponente D) (z.B. Diisocyanat) wird mit etwas Lösungsmittel vorgelegt, dann werden die Komponenten A), B), C) und gegebenenfalls der Katalysator und die Hilfs- und Zusatzstoffe in Lösungsmittel bei Temperaturen von 20 bis 90°C, vorzugsweise 30 bis 70°C, in 0,2 bis 5 Stunden zugegeben. Die Komponenten werden bis zum gewünschten NCO-Gehalt umgesetzt, dann wird in der 2. Stufe der Baustein E) zugesetzt.

Fahrweise 2: Bei diesem Verfahren werden alle Ausgangskomponenten A) bis D) in einem Teil des Lösungsmittels gelöst, so daß die Lösungen mit einem Feststoffgehalt von 15 bis 50 Gew.% gebildet werden. Anschließend werden die Lösungen unter Rühren auf Temperaturen von 20 bis 90°C, vorzugsweise von 30 bis 70°C, gegebenenfalls nach der Katalysatorzugabe, erwärmt. Die Komponenten werden bis zum gewünschten NCO-Gehalt umgesetzt, dann wird in der 2. Stufe der Baustein E) zugegeben.

Fahrweise 3: Die Ausgangskomponenten A), B) und C) werden mit einem Teil der Komponente D) (z.B. dem reaktionsträgeren Isocyanat, wenn Komponente D) ein Gemisch aus mehreren Diisocyanaten ist) in einem Teil des Lösungsmittels bei Temperaturen von 20 bis 90°C, vorzugsweise von 30 bis 70°C, gegebenenfalls nach der Katalysatorzugabe, bis zum vollständigen Umsatz der NCO-Gruppen umgesetzt. Anschließend wird der restliche Teil der Komponente D) zugegeben und die gesamte Reaktionslösung bis zum gewünschten NCO-Gehalt bzw. bis zur gewünschten Viskosität umgesetzt. Danach wird in der zweiten Stufe das Abstoppmittel (Komponente E)) zugegeben.

Beim 2-Stufenverfahren wird nach Fahrweise 1 oder 2 in der ersten Stufe permanent mit einem NCO-Überschuß gegenüber den Bausteinen A bis C gearbeitet. Bei beiden Fahrweisen ist es möglich, in einem Teil des Lösungsmittels die Reaktion zu beginnen und das restliche Lösungsmittel während oder nach der Reaktion zuzugeben.

Als Lösungsmittel für die Herstellung der olefinisch ungesättigten thermoplastischen Polyurethane, insbesondere Polyurethanacrylate, werden vorzugsweise cyclische Ether, wie Tetrahydrofuran und Dioxan, und cyclische Ketone, wie Cyclohexanon, verwendet. Selbstverständlich können je nach Anwendungsgebiet die olefinisch ungesättigten thermoplastischen Polyurethane, insbesondere Polyurethanacrylate, auch in anderen stark polaren Lösungsmitteln, wie Dimethylformamid, N-Methylpyrrolidon, Dimethylsulfoxid oder Ethylglykolacetat gelöst werden. Ebenso ist es möglich, die genannten Lösungsmittel mit Aromaten, wie Toluol oder Xylol und Estern, wie Ethyl- oder Butylacetat, zu mischen.

Als geeignete Katalysatoren zur Herstellung der olefinisch ungesättigten thermoplastischen Polyurethane, insbesondere Polyurethanacrylate, und für die Vernetzungsreaktion seien beispielhaft genannt: tert. Amine, wie Triethylamin, Triethylendiamin, N-Methyl-pyridin und N-Methyl-morpholin, Metallsalze, wie Zinnoctoat, Bleioctoat und Zinkstearat und organische Metallverbindungen, wie Dibutylzinndilaurat. Die geeignete Katalysatormenge ist abhängig von der Wirksamkeit des in Frage kommenden Katalysators. Im

allgemeinen hat es sich als zweckmäßig erwiesen, 0,005 bis 0,3 Gewichtsteile für jeweils 100 Gewichtsteile, vorzugsweise 0,01 bis 0,1 Gewichtsteile für jeweils 100 Gewichtsteile olefinisch ungesättigtes Polyurethan zu verwenden.

Bezogen auf das Gesamtgewicht des Haftlackes werden bevorzugt 70 bis 90, insbesondere 75 bis 85 Gew.-% olefinisch ungesättigtes Polyurethan, besonders bevorzugt Polyurethanacrylat, eingesetzt.

Die erfindungsgemäßen Haftlacke enthalten ein oder mehrere schlagzäh modifizierende Mittel, im folgenden als Kautschuk bezeichnet.

Erfindungsgemäß zu verwendende Kautschuke b) sind beispielsweise Copolymerisate des Ethylens, der Acrylsäure und gegebenenfalls weiterer Comonomerer (DE-A 35 39 469; DE-A 35 40 950 und DE-A 36 02 472). Diese Polymere können gegebenenfalls durch polymeranaloge Umsetzung mit niedermolekularen Substanzen (z.B. der Carboxylgruppen mit Glycidylverbindungen) modifiziert sein. Weiterhin kommen 3-Block-Copolymere von Typ A-B-A oder A-B-C auf Basis Styrol/Butadien bzw. Isopren in Frage (DE-A 29 42 183). Geeignet sind ebenso EP(D)M-Kautschuk (EP-A 326977), Naturkautschuk (Polyisopren) oder Polyurethankautschuk. Die Kautschuke b) werden bevorzugt in Mengen von 2 bis 20, insbesondere 5 bis 10 Gew.-%, bezogen auf das Gesamtgewicht des Haftlackes, eingesetzt.

Die erfindungsgemäßen Haftlacke enthalten vorzugsweise 1 bis 20 Gew.-%, besonders bevorzugt 5 bis 15 Gew.-%, bezogen auf das Gesamtgewicht des Haftlackes, einer niedermolekularen organischen Substanz c), die mehrere Isocyanatgruppen enthält. Beispiele für geeignete Substanzen c) sind Toluylendiisocyanat (TDI) und 4,4'-Diphenylmethandiisocyanat (MDI). Besonders geeignet sind aromatische Polyisocyanate. Besonders bevorzugt wird Desmodur® L, ein aromatisches Polyisocyanat der Bayer AG, verwendet.

Durch die Verwendung der Substanz c) wird in der Regel ein Überschuß von Isocyanatgruppen eingestellt, die beispielsweise mit in der Trägerschicht und reliefbildenden Schicht noch vorhandenen Hydroxylgruppen reagieren können. Im Ergebnis resultiert eine verbesserte Haftung zu diesen Schichten.

Die erfindungsgemäßen Haftlacke können als Zusatzstoffe d) Lichthofschutzmittel enthalten. Da diese die Funktion haben, UV-Strahlung zu absorbieren, eignen sich hierfür zahlreiche Substanzen. Beispiele für geeignete Lichthofschutzmittel, die in Mengen bis zu 0,1 Gew.-% im Haftlacksystem enthalten sein können, sind 4,4'-Bis(N-Hydroxiethyl)-Benzophenon und Basisch-Gelb-Nitrat. Diese werden in Form ihrer Lösungen in THF oder in Mischungen aus THF und Toluol, die bis zu 50 Vol-% Toluol enthalten, eingesetzt. Zu diesen Lösungen können Verlaufshilfsmittel zugegeben sein.

Vorzugsweise wird die Konzentration des Lichthofschutzmittels beispielsweise in THF so gewählt, daß die Extinktion bei 360 nm (1 cm-Küvette) zwischen 0,7 und 1,5, besonders bevorzugt zwischen 0,9 und 1,2 liegt.

Beispiele für weitere mögliche Zusatzstoffe sind Verlaufshilfsmittel beispielsweise auf der Basis von Siloxanen.

Die Zusatzstoffe d) sind in den erfindungsgemäßen Haftlacken bis zu 10 Gew.-%, vorzugsweise bis zu 5 Gew.-% und besonders bevorzugt bis zu 2 Gew.-% enthalten.

Der Haftlack zeigt sowohl auf glatten als auch auf geätzten, auf elektrostatisch vorbehandelten als auch auf nicht vorbehandelten Folien sehr gute Haftung. Die Haftung zur Reliefschicht wird praktisch nicht von deren chemischer Zusammensetzung beeinflußt. Sowohl zu Reliefschichten auf Basis Styrol-Butadien-(Isopren)-Styrol(Butadien) Dreiblock-Copolymeren (DE-A 22 15 090, DE-A 29 42 183, DE-A 24 44 118) als auch zu solchen auf Basis Ethylen-Acrylsäure (DE-A 35 39 469, DE-A 35 40 950, DE-A 36 02 472) oder EPDM-Terpolymeren (EP-A 326 977) und deren Mischungen (EP-A 386 514) sowie zu solchen mit Acrylnitril-Butadien-Polymeren (EP-A 133 265) oder Polyurethan-Kautschuken wurden ausgezeichnete Haftungwerte festgestellt.

Es zeigte sich, daß auch nach einer 6-monatigen Lagerzeit der laminierten Druckplatte keine Abnahme der Haftung festzustellen war. Ebenso konnte kein Unterschied zwischen solchen Haftschichten, die unmittelbar nach dem Beschichten der Folie laminiert wurden und solchen, die vor der Laminierung 6 Monate lagerten, festgestellt werden.

Das erfindungsgemäße Haftlacksystem eignet sich insbesondere für photopolymere Druckplatten. Es kann jedoch auch vorteilhaft als Klebemittel für viele andere Zwecke verwendet werden.

In Auswaschversuchen und bei Auflagendrucken zeigte sich der Haftlack gegenüber den marktgängigen Entwicklern und Farblösungsmitteln besonders resistent.

Beispiele

In den Beispielen sind Laminate bestehend aus einer Trägerfolie, einer Haftschicht aus einem erfindungsgemäßen Haftlacksystem und einer reliefbildenden Schicht beschrieben. Im Vergleichsbeispiel wurde ein Haftlacksystem nach dem Stand der Technik verwendet. Die Trägerfolien und die verschiedenen

reliefbildenden Schichten entsprechen jeweils dem Stand der Technik. Die Molekulargewichtsangaben beziehen sich, sofern nichts anderes angegeben ist, auf das Gewichtsmittel.

In den Beispielen wurden auf vier verschiedene erfindungsgemäße Trägerfolie/Haftschicht-Laminate sehr unterschiedliche Reliefschichten aufgebracht.

Mit den dabei erhaltenen Dreischichtenlaminaten wurden Untersuchungen zur Haftung und Druckversuche unternommen.

Herstellung der Polyurethanacrylat-Komponente

In einem beheizbaren Reaktionsgefäß, ausgerüstet mit Rührer und Rückflußkühler, wurden 8 279 Gew.-Teile eines Polycarbonatdiols (Molekulargewicht ca. 2 000; Diolkomponente: 1,6-Hexandiol, z.B. Desmophen® 2020 der BAYER AG), 5 490 Gew.-Teile eines linearen Copolyesters auf der Basis von Polyethylenterephthalat (z.B. Dynapol® L 206 der Fa. Nobel) (Molekulargewicht ca. 18 000 bis 20 000), 653 Gew.-Teile 1,6-Hexandiol, 2 836 Gew.-Teile ethoxyliertes 2,2-Bis(4-hydroxyphenyl)-propan, 2 554 Gew.-Teile Bisphenol-A-diglycidyldiacrylat und 47 Gew.-Teile Trimethylolpropan zusammen mit 999 Gew.-Teilen Toluylendiisocyanat in 67 000 Gew.-Teilen Tetrahydrofuran gelöst und auf 50 ° C erwärmt.

Die Komponenten wurden bis zum vollständigen Umsatz der Isocyanatgruppen umgesetzt. Danach wurden 5 065 Gew.-Teile 4,4'-Diphenylmethandiisocyanat, gelöst in 5 065 Gew.-Teilen Tetrahydrofuran, ins Reaktionsgefäß hinzugegeben. Diese Reaktionsmischung wurde bei 60 ° C bis zu einer Endviskosität von 4 Pas (bei 60 ° C) umgesetzt.

Anschließend wurde mit 50 800 Gew.-Teilen Toluol auf einen Feststoffgehalt von 16,5 Gew.-% verdünnt. Gleichzeitig wurde die Reaktion durch Zugabe von 195 Gew.-Teilen Dibutylamin abgebrochen.

Der K-Wert des gebildeten Polymeren betrug 61,0, gemessen als 1%ige Lösung in Dimethylformamid.

Herstellung der Trägerfolie/Haftschicht-Laminate

Trägerfolie/Haftschicht-Laminat 1

10 g des wie oben beschrieben hergestellten Polyurethanacrylats wurden mit 1 g Ethylen-Acrylsäure-Kautschuk (EAS-Kautschuk, entsprechend Copolymerisat 3 aus Tabelle 1 der DE-A 35 40 950 aus 43,8 Gew.-% Ethylen, 19,2 Gew.-% Acrylsäure und 37 Gew.-% n-Butylacrylat, 1 g Desmodur® L der BAYER AG (Trimethylolpropan-Toluylen-diisocyanat) und 50 g einer Lösung von 4,4'-Bis(N-Hydroxyethyl)-Benzophenon (Hydroxyethyl-Michlers-Keton) und Basisch-Gelb-Nitrat (2:1) in THF, Extinktion E(1cm/360 nm) = 1,1, in 100 g THF gelöst und auf eine handelsübliche Polyesterfolie aus Polyethylenterephthalat (125 µm) in der Menge aufgebracht, daß sich nach dem Trocknen eine Dicke von 2 µm für die Haftlackschicht ergab. Die Extinktion E(360 nm) betrug 0,40 bis 0,60.

Trägerfolie/Haftschicht-Laminat 2

Die Herstellung erfolgte wie beim Trägerfolie/Haftschicht-Laminat 1, nur daß anstelle des EAS-Kautschuks ein ABC-Dreiblockcopolymer auf der Basis von Styrol/Isopren entsprechend Beispiel 3 der DE-A 29 42 183 verwendet wurde. Das ABC-Dreiblockcopolymer enthielt 15 Gew.-% Polystyrol als Block A, 75 Gew.-% Polyisopren als Block B und 10 Gew.-% eines statistischen Copolymerisats aus gleichen Teilen von Styrol und Isopren als Block C.

Trägerfolie/Haftschicht-Laminat 3

Die Herstellung erfolgte wie beim Trägerfolie/Haftschicht-Laminat 1, nur daß die Polyesterfolie vor dem Beschichten einer Coronaentladung unterworfen wurde.

Trägerfolie/Haftschicht-Laminat 4

Die Herstellung erfolgte wie beim Trägerfolie/Haftschicht-Laminat 1, nur daß die Polyesterfolie mit Trichloressigsäure vorbehandelt wurde.

Herstellung der Dreischichtenlaminate

Beispiel 1

Auf das Trägerfolie/Haftschicht-Laminat 1 wurde mit Hilfe eines Extruders eine photopolymerisierbare Aufzeichnungsschicht aufgetragen. Diese entsprach (vgl. DE-A 38 33 650) einem photopolymerisierbaren Gemisch aus 71,497 Gew.-% eines Terpolymeren aus 58 Gew.-Teilen Ethylen, 21 Gew.-Teilen Acrylsäure und 21 Gew.-Teilen 2-Ethylhexylacrylat (Bindemittel), 6 Gew.-% Glycidylmethacrylat (Monomer), 15 Gew.-% N-n-Butylbenzolsulfonsäureamid (Cetamoll® BMB der BASF AG, Weichmacher), 5 Gew.-% Butylethanolamin (Weichmacher), 1,2 Gew.-% Benzildimethylacetal (Photopolymerisationsinitiator),0,8 Gew.-% N-Nitroso-N-cyclohexylhydroxylamin-kaliumsalz kombiniert mit 0,003 Gew.-% Safranin T (C.I. 50240) (photochromer Zusatz, sensitometrischer Regler) und 0,5 Gew.-% 2,6-Di-tert.-butyl-p-kresol (Inhibitor der thermisch initiierten radikalischen Polymerisation).

Beispiel 2

Auf das Trägerfolie/Haftschicht-Laminat 1 wurde mit Hilfe eines Extruders eine photopolymerisierbare Aufzeichnungsschicht mit der Zusammensetzung gemäß EP-A 326 977, Beispiel 1 aufgetragen.

Diese bestand aus 79,99 Gew.-% des EPDM-Kautschuks ®Buna AP 241 der Firma Bunawerke Hüls GmbH (Ethylengehalt: 50 Gew.-%; Doppelbindungsanteil: 8 Doppelbindungen je 1000 Kohlenstoffatome), 1 Gew.-% Benzildimethylacetal, 5 Gew.-% Isobornylacrylat, 5 Gew.-% Dihydrodicyclopentadienylacrylat, 5 Gew.-% Adipinsäure-di-n-octylester (Dioctyladipat), 0,01 Gew.-% Phthalocyaninfarbstoff Siccoflush D (C.I. 74260) und 5 Gew.-% 2,6-Di-tert.-butyl-p-kresol.

Beispiel 3

Auf das Trägerfolie/Haftschicht-Laminat 1 wurde mit Hilfe eines Extruders eine photopolymerisierbare reliefbildende Schicht entsprechend Beispiel 13 in DE-PS 22 15 090 aufgetragen.

Diese bestand aus 72,1 Gew.-% eines Polystyrol-Polyisopren-Polystyrol-Blockmischpolymerisats ($\overline{M}_w$) = 100 000, Polyisoprenblock: 85 Gew.-%), 6,0 Gew.-% Hexamethylenglykoldiacrylat, 0,75 Gew.-% Benzoinmethylether, 0,18 Gew.-% 2,6-Di-tert.-butyl-4-methylphenol, 8,0 Gew.-% naphthenisches Öl, 12,0 Gew.-% $\alpha$-Methylstyrol-Vinyltoluol-Copolymerisat (Schmelzviskosität etwa 10 Poise bei 160 °C) und 1,0 Gew.-% mikrokristallines Wachs.

Beispiel 4

Auf das Trägerfolie/Haftschicht-Laminat 1 wurde mit Hilfe eines Extruders eine photopolymerisierbare reliefbildende Schicht mit einer Zusammensetzung gemäß EP-A 133 265, Beispiel 1, aufgetragen. Diese bestand aus 48,3 Gew.-% eines Butadien/Acrylnitril-Copolymerisats (Acrylnitril-Gehalt: 30 %; Mooney-Viskosität ML 4:40), 5 Gew.-% Hexandioldiacrylat, 5 Gew.-% Hexandioldimethacrylat, 1,2 Gew.-% Benzildimethylketal, 1 Gew.-% einer pyrogenen Kieselsäure ($SiO_2$-Gehalt: > 99,8 %; Oberfläche nach BET: 380 $m^2/g$; Primärteilchengröße: 7 nm), 0,5 Gew.-% 2,6-Di-tert.-butyl-p-kresol, 30 Gew.-% Dibutylphthalat sowie 0,006 Gew.-% des Farbstoffs Sudantiefschwarz BB.

Beispiel 5

Auf das Trägerfolie/Haftschicht-Laminat 1 wurde mit Hilfe eines Extruders eine photopolymerisierbare reliefbildende Schicht entsprechend DE-A 36 30 474, Beispiel 3, aufgetragen. Diese Schicht bestand aus 82 Gew.-% ABC-Blockcopolymerisat (gemäß DE-A 29 42 183, Beispiel 3), 4 Gew.-% Hexandioldiacrylat, 2 Gew.-% Hexandioldimethacrylat, 6 Gew.-% 2-Ethylhexylacrylat, 1 Gew.-% Benzildimethylketal, 0,005 Gew.-% Farbstoff SSBB (Sudantiefschwarz), 1 Gew.-% 2,6-Di-(t-butyl)kresol, 1 Gew.-% Ozonschutzwachs (Antilux® 550) und 3 Gew.-% $\alpha$-Methylstyrol/Vinyltoluol-Copolymer ($M_N$ 1500).

Beispiel 6

Auf das Trägerfolie/Haftschicht-Laminat 2 wurde mit Hilfe eines Extruders eine reliefbildende Schicht entsprechend Beispiel 3 aufgetragen.

Beispiel 7

Auf das Trägerfolie/Haftschicht-Laminat 3 wurde mit Hilfe eines Extruders eine reliefbildende Schicht entsprechend Beispiel 3 aufgetragen.

Beispiel 8

Auf das Trägerfolie/Haftschicht-Laminat 4 wurde mit Hilfe eines Extruders eine reliefbildende Schicht entsprechend Beispiel 3 aufgetragen.

Vergleichsbeispiel

Auf einen Träger nach EP-A 64 564, Beispiel 1, mit einer Standardhaftschicht auf Basis eines Phenoxyharzes wurde eine reliefbildende Schicht gemäß Beispiel 5 aufgetragen.

Die an den Dreischichten-Laminaten der Beispiele 1 bis 8 und des Vergleichsbeispiels gemessenen Haftwerte sind in der Tabelle angegeben.

Die Haftwerte wurden mittels einer Zugprüfmaschine ermittelt. Hierzu wurden 2 cm breite und 10 cm lange Stücke aus den Dreischichtenlaminaten der Beispiele 1 bis 8 und des Vergleichsversuchs verwendet. An der schmalen Seite wurde das Trägerfolie/Haftschicht-Laminat von der reliefbildenden Schicht teilweise entfernt und beide Teile eingeklemmt. Im anschließenden Zugversuch wurde an beiden Teilen in entgegengesetzter Richtung gezogen. Die Haftwerte in Tabelle 1 sind in Newton, bezogen auf eine Laminatbreite von 2 cm, angegeben.

Für die Haftversuche wurden Dreischichtenlaminate verwendet, bei denen innerhalb von wenigen Tagen nach Herstellung des Trägerfolie/Haftschicht-Laminats die reliefbildende Schicht aufgebracht wurde und solche, bei denen das Trägerfolie/Haftschicht-Laminat sechs Monate gelagert worden war (Raumtemperatur, Luftfeuchtigkeit 50 bis 70 %), bevor die reliefbildende Schicht aufgebracht wurde.

In beiden Fällen wurden die Haftversuche an den frisch hergestellten Dreischichtenlaminaten durchgeführt. Im ersten Fall wurden außerdem Haftversuche nach einer Lagerungszeit der Dreischichtenlaminate von sechs Monaten durchgeführt (Lagerbedingungen wie oben).

Tabelle

| Beispiele | Haftwerte [N/2cm] a) | b) | c) | Druckauflage |
|---|---|---|---|---|
| 1 | 12 | 13 | 10 | > 100 000 |
| 2 | 7-12 | 12 | 10 | > 100 000 |
| 3 | 40-50 | 40 | 35-45 | > 100 000 |
| 4 | 20-30 | 25 | 20-30 | > 100 000 |
| 5 | d) | d) | d) | > 100 000 |
| 6 | >20 | >20 | >20 | |
| 7 | >20 | >20 | >20 | |
| 8 | >20 | >20 | >20 | |
| Vergleichs-Beisp. | >20 | < 1 | >20 | |

Es bedeuten:

a) Herstellung des Dreischichtenlaminates innerhalb von wenigen Tagen; anschließend Haftversuch.

b) Herstellung des Dreischichtenlaminates innerhalb von wenigen Tagen; Haftversuch nach 6 Monaten Lagerung.

c) Lagerung des Trägerfolie/Haftschicht-Laminates für 6 Monate; dann erst Herstellung des Dreischichtenlaminates; anschließend Haftversuch.

d) nicht meßbar, Schicht reißt vorher.

Bei den erfindungsgemäßen Beispielen 1 bis 8 wurde ein sehr gutes bis gutes Haftungsniveau gefunden. Haftungsversagen durch Verspröden der Dreischichtenlaminate nach 6-monatiger Lagerung wie beim Vergleichsbeispiel oder durch Nachlassen des Haftungsniveaus bei 6-monatiger Lagerung des Trägerfolie/Haftschicht-Laminates vor der Herstellung des Dreischichtenlaminates trat nicht auf.

Alle erfindungsgemäßen Platten wurden bei der Herstellung um 50 % überwaschen d.h. 50 % länger

entwickelt als notwendig. Es traten in keinem Fall Schäden auf, die auf ein Haftungsversagen zurückzuführen waren. Im Druck wurden mit allen Platten hohe Auflagen erreicht. Es wurde gefunden, daß die Farblösungsmittel die gute Haftung nicht beeinträchtigen.

Bei dem Vergleichsbeispiel entsprechend dem Stand der Technik wurde nach 6-monatiger Lagerzeit des Dreischichten-Laminats Haftungsversagen durch Monomerdiffusion festgestellt.

**Patentansprüche**

**1.** Haftsystem für photopolymere Druckplatten, enthaltend als wesentliche Komponenten
   a) ein olefinisch ungesättigtes thermoplastisches Polyurethan,
   b) ein schlagzäh modifizierendes Mittel und
   c) mindestens eine niedermolekulare organische Substanz mit mehreren Isocyanatgruppen.

**2.** Haftsystem nach Anspruch 1, dadurch gekennzeichnet, daß das olefinisch ungesättigte thermoplastische Polyurethan ein Molekulargewicht ($\overline{M}_w$) im Bereich von 40 000 bis 200 000 aufweist, und aus
   A) einem Gemisch aus
      A1) einem Polydiol mit einem Molekulargewicht zwischen 400 und 4 000

      und
      A2) einem Polydiol mit einem Molekulargewicht von größer 14 000,
   B) einem Gemisch aus
      B1) einem oder mehreren nicht olefinisch ungesättigten Diolen mit 2 bis 20 Kohlenstoffatomen

      und
      B2) einem oder mehreren Diolen mit 2 bis 20 Kohlenstoffatomen mit jeweils mindestens einer olefinisch ungesättigten Bindung,
   C) mindestens einem Tri- oder Polyol mit 3 bis 10 Kohlenstoffatomen,
   D) mindestens einem Diisocyanat mit 6 bis 30 Kohlenstoffatomen

   und
   E) mindestens einem Monoamin oder Aminoalkohol mit 2 bis 16 Kohlenstoffatomen
hergestellt wird.

**3.** Haftsystem nach Anspruch 2, dadurch gekennzeichnet, daß das olefinisch ungesättigte thermoplastische Polyurethan aus
   A) 1 Mol eines Gemisches aus
      A1) einem Polydiol mit einem Molekulargewicht zwischen 400 und 4 000

      und
      A2) einem Polydiol mit einem Molekulargewicht von größer 14 000,
      wobei das Molverhältnis der Komponente A1) zu der Komponente A2) ≧ 10 ist,
   B) 0,3 bis 10 Mol eines Gemisches aus
      B1) einem oder mehreren nicht olefinisch ungesättigten Diolen mit 2 bis 20 Kohlenstoffatomen

      und
      B2) einem oder mehreren Diolen mit 2 bis 20 Kohlenstoffatomen mit jeweils mindestens einer olefinisch ungesättigten Bindung,
   wobei das Molverhältnis der Komponente B1) zu der Komponente B2) ≦ 30 ist,
   C) 0,05 bis 0,5 Mol mindestens einem Tri- oder Polyol mit 3 bis 10 Kohlenstoffatomen,
   D) 1,3 bis 13 Mol mindestens einem Diisocyanat mit 6 bis 16 Kohlenstoffatomen

   und
   E) 0,09 bis 2 Mol mindestens einem Monoamin mit 2 bis 16 Kohlenstoffatomen
hergestellt wird, mit der Maßgabe, daß das Verhältnis der OH-Gruppen der Komponenten A) bis C) zu den NCO-Gruppen der Komponente D) zu den Aminogruppen der Komponente E) wie 1 zu 1,03 bis 1,3 zu 0,03 bis 0,3 beträgt.

4. Haftsystem nach Anspruch 2 oder 3, dadurch gekennzeichnet, daß die Komponente B2) mindestens eine Acrylatdoppelbindung aufweist.

5. Haftsystem nach einem der Ansprüche 2 bis 4, dadurch gekennzeichnet, daß die Komponenten so gewählt sind, daß A1) ein Polycarbonatdiol auf Basis von 1,6-Hexandiol, A2) ein linearer Copolyester auf Basis von Polyethylenterephthalat, B1) Hexandiol und/oder ethoxyliertes 2,2-Bis(4-hydroxyphenyl)-propan, B2) Bisphenol-A-diglycidyldiacrylat, C) Trimethylolpropan, D) ein Toluylendiisocyanat und/oder 4,4'-Diphenylmethandiisocyanat und E) Dibutylamin ist.

6. Haftsystem nach einem der Ansprüche 1 bis 5, dadurch gekennzeichnet, daß es aus

| | |
|---|---|
| 70 bis 90 Gew.-% | eines olefinisch ungesättigten thermoplastischen Polyurethans a), |
| 2 bis 20 Gew.-% | eines schlagzäh modifizierenden Mittels b), |
| 1 bis 20 Gew.-% | mindestens einer niedermolekularen organischen Substanz c) mit mehreren Isocyanatgruppen und |
| bis zu 5 Gew.-% | an Zusatzstoffen d) |

besteht.

7. Photopolymere Druckplatte, dadurch gekennzeichnet, daß sie mindestens ein Haftsystem nach einem der Ansprüche 1 bis 6 enthält.

Europäisches Patentamt

# EUROPÄISCHER RECHERCHENBERICHT

Nummer der Anmeldung

EP 92 10 0714

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | FR-A-2 225 295 (TEIJIN LIMITED)<br>* Seite 4, Zeile 15 - Seite 4, Zeile 30; Ansprüche; Beispiel 8 *<br>--- | 1-7 | G03F7/11<br>C09J175/14 |
| A | EP-A-0 053 260 (BASF AKTIENGESELLSCHAFT)<br>* Ansprüche *<br>--- | 1-7 | |
| A | EP-A-0 058 737 (E.I.DU PONT DE NEMOURS AND COMPANY)<br>* Ansprüche; Beispiel 3 *<br>--- | 1-7 | |
| A | WORLD PATENTS INDEX LATEST<br>Week 4385,<br>Derwent Publications Ltd., London, GB;<br>AN 85-268800<br>& SU-A-1 150 613 (UKR PRINTING IND RE) 15. April 1985<br>* Zusammenfassung *<br>----- | 1-7 | |

| RECHERCHIERTE SACHGEBIETE (Int. Cl.5 ) |
|---|
| G03F<br>C09J |

Der vorliegende Recherchenbericht wurde für alle Patentansprüche erstellt

| Recherchenort | Abschlußdatum der Recherche | Prüfer |
|---|---|---|
| DEN HAAG | 19 MAI 1992 | D. Hillebrecht |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPO FORM 1503 03.82 (P0403)